(19) Europäisches Patentamt / European Patent Office / Office européen des brevets

(11) **EP 2 031 412 B1**

(12) **EUROPÄISCHE PATENTSCHRIFT**

(45) Veröffentlichungstag und Bekanntmachung des Hinweises auf die Patenterteilung:
**26.02.2014 Patentblatt 2014/09**

(51) Int Cl.:
***G01R 15/20*** *(2006.01)*

(21) Anmeldenummer: **08105089.0**

(22) Anmeldetag: **21.08.2008**

(54) **Vorrichtung zur galvanisch getrennten Messung der elektrischen Leistungsaufnahme eines Zweipols**

Device for galvanically separated measurement of the electric power picked up by a two-pole network

Dispositif de mesure galvanique séparée de la réception de puissance électrique d'un bipôle

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **27.08.2007 DE 102007040399**

(43) Veröffentlichungstag der Anmeldung:
**04.03.2009 Patentblatt 2009/10**

(73) Patentinhaber: **Siemens Aktiengesellschaft**
**80333 München (DE)**

(72) Erfinder: **Weiß, Dr. Roland**
**91058, Erlangen (DE)**

(56) Entgegenhaltungen:
| | |
|---|---|
| EP-A2- 0 286 079 | WO-A1-98/57188 |
| WO-A1-03/019216 | WO-A1-03/025604 |
| DE-A1- 3 133 908 | DE-A1- 4 434 417 |
| US-A- 4 504 787 | US-A- 4 525 668 |

# EP 2 031 412 B1

**Beschreibung**

Die Erfindung bezieht sich auf eine Vorrichtung zur galvanisch getrennten Messung der elektrischen Leistungsaufnahme eines Zweipols gemäß dem Oberbegriff des Patentanspruches 1.

MR-Sensoren, insbesondere GMR Sensoren, stellen in der magnetfeldbasierten Positions-, Geschwindigkeits-, Drehzahl-, Feld- oder auch Stromsensorik eine Alternative zu Hallsensoren dar. Vor allem im Bereich der Positions- und Stromsensorik sind während der letzten Jahre verstärkt MR-basierte Sensoren in den Markt eingeführt worden. Die Hauptvorteile - im Vergleich zu Hall-Sensoren - liegen im einfacheren Systemaufbau, der größeren Störsicherheit, bedingt durch die Möglichkeit eines Designs mit stark reduzierter Fremdfeldempfindlichkeit, und dem geringeren Rauschen.

Es bieten sich bei MR-basierten Sensoren vor allem vollintegrierte Lösungen an, da die MR-Elemente als "back-end"-Prozess im Rahmen eines CMOS-Prozesses aufgebracht werden können und damit keine zusätzliche Chipfläche beanspruchen.

Für viele Anwendungen, vor allem in der Positions-, Drehzahlund Stromsensorik, werden jeweils vier MR-Elemente zu einer sog. Wheatstone-Brücke verschaltet um eine genauere, von Temperaturschwankungen, Fremdfeldern usw. unabhängigere Messung zu erreichen. Vor allem um den Einfluss von Fremdfeldern zu unterdrücken wird über eine Stromschleife ein Differenzfeld erzeugt, wobei die Brückenelemente so positioniert werden, dass die Ausgangsspannung stark von dem durch die Stromschleife erzeugten Differenzfeld jedoch nicht von eventuell auftretenden homogenen Störfeldern beeinflusst wird.

Neben der reinen galvanisch getrennten Stromerfassung, die eine solche Anordnung ermöglicht, ist aber insbesondere eine Erfassung der elektrischen Leistungsaufnahme eines Zweipoles ermöglicht. Die Erfassung von Strom und Spannung erfolgt in einem Stromkreis unter Verwendung von XMR-Sensoren, welche zu Wheatstone-Brücken verschaltet sind.

[DE 31 33 908 A1] betrifft einen kompensierten Messwandler, bei welchem zur Bildung eines linearen Abbildes eines in einem Messleiter fließenden Messstromes eine Magnetfeldsonde einem vom Messstrom erzeugten Messmagnetfeld sowie einem Kompensationsmagnetfeld ausgesetzt ist. Die Magnetfeldsonde ist eine aus vier magnetoresistiven Dünnfilmen bestehende Brücke.

[EP 0 286 79 A2] betrifft einen Sensor mit einem magnetoelektrischen Messwandler zur Messung elektrischer Ströme oder elektrischer Spannungen. Der Sensor umfasst vier magnetoresistive Elemente, welche in Form einer Brückenschaltung zusammengeschaltet sind. Dabei kann auch eine Vielzahl von magnetoresistiver Elementen in Serie angeordnet sein.

[US 4,916,455] beschreibt eine Anordnung zur Energieverbrauchsmessung, welche parallel angeordnete Leiterplatten umfasst, über welche die zu messende Energie geführt ist. Dabei ist eine magnetoresistive Wheatstone-Brücke zwischen den Leiterplatten angeordnet, durch welchen ein Messsignal erzeugt wird, mit Hilfe dessen der Gesamt-Energieverbrauch ermittelt werden kann.

[DE 44 34 417 A1] beschreibt eine Messanordnung zur Messung eines durch einen Stromleiter fließenden elektrischen Stromes mit Hilfe eines Messgliedes in Form einer als Wheatstone-Brücke ausgestalteten Messbrücke aus magnetoresistiven Messwiderständen. An die Messbrücke ist eine elektrische Brückenspannung angelegt, wobei von der Messbrücke zur Messung einer von dem Strom in der unmittelbaren Umgebung des Stromleiters erzeugten magnetischen Feldstärke eine Messspannung abgegriffen wird, welche einen Kompensationsstrom beeinflusst, der proportional dem zu messenden Strom ist.

Neben der reinen galvanisch getrennten Stromerfassung, die eine solche Anordnung ermöglicht, ist aber insbesondere eine kompakte, störsichere und kostengünstige galvanisch getrennte Messung der elektrischen Leistung von Interesse.

Zur galvanisch getrennten Erfassung der elektrischen Momentanleistung ist zusätzlich zur Strom-Istwert-Messung auch eine separate Spannungs-Istwert-Messung notwendig. Die galvanisch getrennte Erfassung von elektrischen Potentialdifferenzen bzw. Spannungen erfolgt in kommerziellen Systemen im Allgemeinen über einen Vorwiderstand und einem galvanisch getrennten Stromsensor. Zum Teil werden auch Systeme, die im Versorgungspfad, z. B. mittels Batterie, und im Signalpfad, z. B. mittels Optokoppler oder Magnetokoppler, entkoppelt, also galvanisch getrennt sind, eingesetzt und die ansonsten Strom und Spannung konventionell messen, beispielsweise den Strom über einen Shuntwiderstand und die Spannung über einen Spannungsteiler. Der Systemaufbau dieser Leistungsmesser ist vergleichsweise aufwendig und teuer.

Davon ausgehend ist es Aufgabe der Erfindung, eine Vorrichtung zu schaffen, die einfach aufgebaut und zur galvanisch getrennten Erfassung einer elektrischen Momentanleistung im Zweipol geeignet ist.

Die Aufgabe ist erfindungsgemäß durch die Gesamtheit der Merkmale des Patentanspruches 1 gelöst. Weiterbildungen sind in den Unteransprüchen angegeben.

Gegenstand der Erfindung ist eine Anordnung von MR-Sensoren (AMR-, GMR-, TMR-, OMR-Sensoren), die allgemein als XMR-Sensoren bezeichnet werden, vorzugsweise GMR-Sensoren, die zu mindestens zwei Wheatstone-Brücken verschaltet sind. Die Anordnung der XMR-Sensoren als genau zwei Wheatstone-Brücken befindet sich dabei über einer Leiterschleife mit paralleler Hin- und Rückleitung (sog. U-Turn), wobei bei geeigneter Auslegung von Leiterschleife und Anordnung der Wheatstone-Brücken sowohl der elektrische Strom als auch die elektrische Spannung eines elektrischen Zweipols galvanisch getrennt erfasst werden können. Dabei wird berücksichtigt, dass sich bei Anlegen einer Spannung und Bestromung mittels von zwei Spulen, die über der Leiterschleife gegenläufig zueinander angeordnet sind, im Bereich der beiden Wheatstone-Brücken zwei Gradientenfelder ergeben, von denen das eine dem des zu messenden Stromes gleich und das andere das dem zu messenden Stromes entgegengesetzt gerichtet ist.

Bei der Erfindung befinden sich bei Stromfluss vorteilhafterweise beide Wheatstone-Brücken im Magnetfeld der Leiterschleife, die so ausgelegt ist, dass sich ein Gradienten-/Differenzfeld ergibt. Die Wheatstone-Brücken sind so dabei angeordnet, dass sie durch das Differenzfeld des Primärstromes eine maximale Verstimmung erfahren. Beide Wheatstone-Brücken befinden sich in Bereichen, die einen vergleichbaren Magnetfeldverlauf des durch den Primärstrom hervorgerufenen Magnetfeldes aufweisen. Die Spannungsmessung kann über einen Widerstand in einem Parallelkreis zum Zweipol, der den Strom $I_v$ erzeugt, erfolgen.

Bei der Erfindung führt der Strom $I_v$ in wenigstens zwei Spulenanordnungen, vorteilhafterweise in Flachspulen, zu zwei Gradienten-/Differenzfeldern, die zueinander entgegengesetzt gerichtet sind. Die Überlagerung der Differenzfelder des Primärstromes $I_p$ und des Stroms $I_v$ wird von den beiden Brückenanordnungen in zwei Signale umgewandelt, aus welchen wiederum $I_p$ und $I_v$ berechnet werden können.

Vorzugsweise erfolgt die Spannungsmessung über einen Vorwiderstand von geeigneter Größe, insbesondere von einigen k$\Omega$. Der durch den Vorwiderstand fließende Strom erzeugt also mittels der mindestens zwei Flachspulen mindestens zwei unterschiedliche Gradienten-/Differenzfelder, die im Allgemeinen entgegen gesetzt gerichtet sind.

Bei der Erfindung besitzen die Flachspulen vorzugsweise mehrere Lagen, um bei möglichst kleinem Strom $I_v$ ein solches Gradienten-/Differenzfeld zu erzeugen, welches dem Betrage nach bei Nennbetrieb etwa dem des Primärstromes $I_p$ entspricht. Im Bereich der ersten Wheatstone-Brücke addieren sich die beiden Gradienten-/Differenzfelder, d.h. das Gradienten-/Differenzfeld der Strommessung vom Primärstrom, und das Gradienten-/Differenzfeld der Spannungsmessung, d.h. der Strom über einen Vorwiderstand und die Flachspule. Im Bereich der zweiten Wheatstone-Brücke subtrahieren sich die beiden Gradienten-/Differenzfelder, d.h. das Gradienten-/Differenzfeld des Primärstromes $I_p$ und das Gradienten-/Differenzfeld der Spannungsmessung. Damit ist vorteilhafterweise die galvanisch getrennte Erfassung von Strom und Spannung sowie daraus die Bestimmung der elektrischen Leistung möglich.

Wesentlich ist also bei der Erfindung, dass wenigstens zwei aus XMR-Sensoren gebildete Wheatstone-Brücken sich "in plane" auf einem einzigen Substrat befinden. Dadurch lassen sich der integrierte Aufbau der neuen Vorrichtung und insbesondere auch dessen Herstellung gegenüber dem Stand der Technik wesentlich vereinfachen.

Weitere Einzelheiten und Vorteile der Erfindung ergeben sich aus der nachfolgenden Figurenbeschreibung von Ausführungsbeispielen anhand der Zeichnung in Verbindung mit den Patentansprüchen.

Es zeigen

Figur 1    eine Draufsicht auf die neue Anordnung mit den wesentlichen Strukturen,
Figur 2    eine Seitenansicht bzw. ein Schnitt der Anordnung gemäß Figur 1 und
Figur 3    ein elektrisches Blockschaltbild für die Anordnung gemäß den Figuren 1/2.

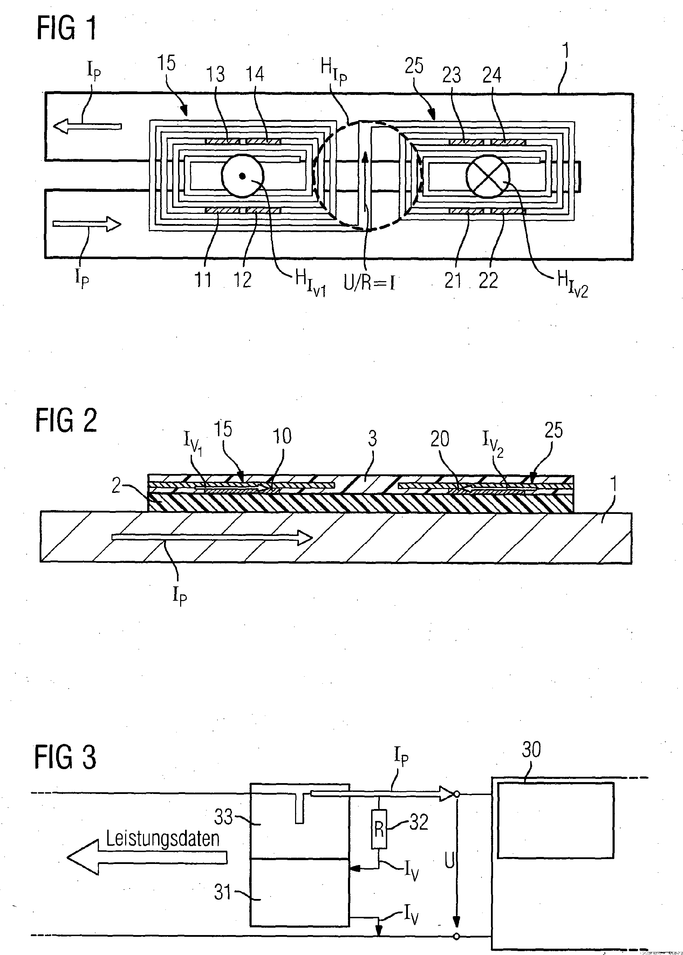

Gleiche Elemente haben in den Figuren gleiche bzw. sich entsprechende Bezugszeichen. Insbesondere die Figuren 1 und 2 werden gemeinsam beschrieben.

In den Figuren 1 und 2 bedeutet 1 eine Leiterbahn, durch die ein Primärstrom $I_p$ geschickt wird. Wesentlich ist dabei, dass die Leiterbahn U-förmig verläuft, was als U-Turn bezeichnet wird. Auf der Leiterbahn 1 ist in der Schnittdarstellung eine Isolationsschicht 2 erkennbar, auf der - in eine weitere Isolationsschicht 3 eingebettet - zwei Brückenschaltungen 10 und 20 nach Art einer Wheatstone-Brücke aus jeweils vier XMR-Elementen 11 bis 14 bzw. 21 bis 24 eingebracht sind. Die Elemente 11 bis 14 und 21 bis 24 für die Brückenschaltungen 10 und 20 sind Dünnschichtelemente und können im Rahmen eines so genannten "back end"-Prozesses nachfolgend in CMOS-Technologie, mit dem die Auswerteschaltung realisiert wird, auf das gleiche Substrat aufgebracht werden.

Die beiden Wheatstone-Brücken 10 und 20 weisen als XMR-Elemente 11 bis 14 und 21 bis 24 vorteilhafterweise solche GMR(Giant Magnetic Resistive)-Sensoren auf, die nach dem Spinvalve-Prinzip arbeiten. Entsprechend arbeitende TMR (Tunnel Magnetic Resistive)-Sensoren bzw. OMR(Organic Magnetic Resistive)-Sensoren sind ebenfalls geeignet. Aber auch andere MR-Sensoren, beispielsweise AMR-Sensoren, sind einsetzbar.

Auf den zur Brücke geschalteteten Sensoren 11 bis 14 bzw. 21 bis 24 befinden sich jeweils eine Flachspule 15 bzw. 25, durch die Ströme $I_{v1}$ bzw. $I_{v2}$ in entgegengesetzter Richtung fließen. Die Flachspulen 15 bzw. 25 können vorteilhafterweise mehrlagig aufgebaut sein.

Derartige Aufbauten mit Brückenschaltungen von XMR-Elementen sind vom Stand der Technik bekannt. Wesentlich ist im vorliegenden Zusammenhang, dass mit beiden Flachspulen 15, 25 eine Spannungsmessung erfolgen kann, wobei die Anordnung so gewählt ist, dass eine gegenseitige Störung der magnetischen Felder für Strom und Spannungsmessung vermieden wird.

In den Brücken 10 und 20 gelten für die darin erzeugten Brückenspannungen nachfolgende Gleichungen (1) und (2):

$$U_{B1} = F_1\left(g_1 \cdot I_P + a_1 \cdot \frac{U}{R}\right) \approx \overline{g_1} \cdot I_P + \overline{a_1} \cdot \frac{U}{R} \qquad (1)$$

$$U_{B2} = F_2\left(g_2 \cdot I_P - a_2 \cdot \frac{U}{R}\right) \approx \overline{g_2} \cdot I_P - \overline{a_2} \cdot \frac{U}{R} \quad , \qquad (2)$$

wobei die Symbole folgende Bedeutung haben:

| | |
|---|---|
| $U_{B1}$: | Brückenspannung der ersten Brücke |
| $U_{B2}$: | Brückenspannung der zweiten Brücke |
| R: | Vorwiderstand |
| $I_p$: | Strom (Primärstrom) |
| U: | Spannung |
| $F_2$: | normierte Übertragungsfunktionen der Brücke |
| $a_1, a_2, g_1, g_2$: | Skalierungsfaktoren |

Aus den Brückensignalen kann nach einer geeigneten Filterung und einer Analog/Digitalwandlung sowohl der Strom als auch die Spannung wieder berechnet werden. Es gilt:

$$(g_1 + g_2) \cdot I_P = F_1^{-1}(U_{B1}) + F_2^{-1}(U_{B2}) \qquad (3a)$$

$$(a_1 + a_2)\frac{U}{R} = F_1^{-1}(U_{B1}) - F_2^{-1}(U_{B2}) \qquad (3b)$$

$$\frac{(g_1 + g_2)}{(a_1 + a_2)} \approx 100...4000 \qquad (3c)$$

In der Figur 3 bedeuten 30 einen aktiven oder passiven Zweipol, der auch als Eintor bezeichnet wird. Es ist ersichtlich, dass in dem in Figur 3 dargestellten Netzwerk die Spannung mit einer Einheit 31 und der Strom über einen Vorwiderstand 32 in einer Einheit 33 erfasst werden können, wobei eine galvanische Trennung vorliegt.

Aus den erfassten Werten für Strom $I_p$ und Spannung U kann der momentane Wert der Leistung durch einfache Multiplikation der digitalisierten Werte berechnet werden. Über eine einfache Integration bzw. Summenbildung kann dann dieser Wert in üblicher Weise zu einem zeitlichen Mittelwert - wie beispielsweise für stationäre Signale üblich - weiter verarbeitet werden. Es gilt Gleichung (4):

$$\overline{P} = \frac{1}{T}\int_{t_0}^{t_0+T} P\,dt = \frac{1}{T}\int_{t_0}^{t_0+T} U \cdot I\,dt \qquad (4)$$

mit

$\overline{P}$:  mittlere Leistung

P:  Momentanleistung

T:  Periodendauer

to:  Startzeitpunkt

Es ist somit eine Messvorrichtung zur galvanisch getrennten Messung und damit möglichen Echtzeit-Erfassung der elektrischen Leistung gegeben. Der wesentliche Vorteil gegenüber dem Stand der Technik besteht darin, dass durch ein einziges System in direkter räumlicher Nähe, d.h. unmittelbarer Nachbarschaft in der gleichen Vorrichtung, sowohl Spannung als auch Strom galvanisch getrennt erfasst werden können. Der Aufbau der beiden mit "in plane" aus XMR-Sensoren ausgebildeten Wheatstone-Brücken erfolgt in der gleichen Technologie, die im Fall der GMR-Technologie erwiesenermaßen als "back end"-Prozess mit einer CMOS-Technologie geeignet ist. Damit kann das gesamte Messsystem zusammen mit der Signalverarbeitung auf einem einzigen Substrat realisiert werden.

Durch die gezielte Überlagerung der durch separate Spulen erzeugten magnetischen Felder können vorteilhafterweise Störungen bei der eng benachbarten Strom- und Spannnungsmessung vermieden werden.

**Patentansprüche**

1.  Vorrichtung zur galvanisch getrennten Messung der elektrischen Leistungsaufnahme eines Zweipols aus der Erfassung von Strom und Spannung in einem Stromkreis unter Verwendung von XMR-Sensoren, die zu Wheatstone-Brücken verschaltet sind, wobei

    - wenigstens zwei Wheatstone-Brücken (10, 20) mit den einzelnen XMR-Sensoren (11 bis 14, 21 bis 24) an einer Leiterschleife (1) aus Hin- und Rückleitung (U-Turn) derart angeordnet sind, dass sich bei Stromfluss durch die Leiterschleife (1) aufgrund des zugehörigen Magnetfeldes im Bereich der wenigstens zwei Wheatstone-Brücken (10, 20) Gradienten-/Differenzfelder ($H_{Iv1}$, $H_{Iv2}$) ausbilden,
    - wenigstens zwei Spulenanordnungen (15, 25) derart an der **dadurch gekennzeichnet, dass** Leiterschleife angeordnet sind, dass bei Bestromung der Leiterschleife (1) zwei unterschiedliche Gradienten-/Differenzfelder entgegen gesetzter Richtung im Bereich der beiden Wheatstone-Brücken erzeugt (10, 20) werden
    - und wobei zur Spannungsmessung ein Vorwiderstand (32) zur Bestromung der wenigstens zwei Spulenanordnungen mittels des durch ihn fließenden Stroms vorhanden ist.

2.  Vorrichtung nach Anspruch 1, **dadurch gekennzeichnet, dass** genau zwei Wheatstone-Brücken (10, 20) vorhanden sind, die derart über der Leiterschleife (1) angeordnet sind, dass sie durch das jeweilige Gradienten-/Differenzfeld eine maximale Verstimmung erfahren.

3.  Vorrichtung nach Anspruch 2, **dadurch gekennzeichnet, dass** beide Wheatstone-Brücken (10, 20) sich in Bereichen befinden, die einen vergleichbaren Magnetfeldverlauf des durch den Primärstrom hervorgerufenen Magnetfeldes aufweisen.

4.  Vorrichtung nach einem der vorhergehenden Ansprüche, **dadurch gekennzeichnet, dass** die XMR-Sensoren (11 bis 14, 21 bis 24) AMR-, GMR-, TMR- oder OMR-Sensoren, insbesondere GMR-Sensoren, sind.

5.  Vorrichtung nach einem der vorhergehenden Ansprüche, **dadurch gekennzeichnet, dass** der zur Spannungsmessung vorhandene Vorwiderstand ein Vorwiderstand (32) von einigen kΩ ist.

6.  Vorrichtung nach einem der vorhergehenden Ansprüche, **dadurch gekennzeichnet, dass** die wenigstens zwei Spulenanordnungen (15, 25) als Flachspulen ausgestaltet sind.

7.  Vorrichtung nach einem der vorhergehenden Ansprüche, **dadurch gekennzeichnet, dass** der Vorwiderstand (32) in Wirkverbindung zu den beiden Flachspulen (15, 25) angeordnet ist.

8.  Vorrichtung nach Anspruch 6, **dadurch gekennzeichnet, dass** die Flachspulen (15, 25) mehrere Lagen aufweisen und bei kleinem Strom ($I_V$) ein Gradienten-/Differenzfeld erzeugen, das dem Betrage nach bei Nennbetrieb im Wesentlichen dem Betrag des Feldes des Primärstromes ($I_P$) entspricht,.

9.  Vorrichtung nach Anspruch 8, **dadurch gekennzeichnet, dass** für die Brückenspannungen der Wheatstone-Brük-

ken (10, 20) gilt:

$$U_{B1} = F_1\left(g_1 \cdot I_P + a_1 \cdot \frac{U}{R}\right) \approx \overline{g_1} \cdot I_P + \overline{a_1} \cdot \frac{U}{R} \qquad (1)$$

$$U_{B2} = F_2\left(g_2 \cdot I_P - a_2 \cdot \frac{U}{R}\right) \approx \overline{g_2} \cdot I_P - \overline{a_2} \cdot \frac{U}{R} \qquad (2)$$

wobei die Symbole folgende Bedeutung haben:

$U_{B1}$ : Brückenspannung der ersten Brücke,
$U_{B2}$ : Brückenspannung der zweiten Brücke,
R: Vorwiderstand
$I_P$: Primärstrom
U: Spannung
$F_{1,2}$: normierte Übertragungsfunktion der Brücke
$a_1$, $a_2$, $g_1$, $g_2$: Skalierungsfaktoren.

**10.** Vorrichtung nach Anspruch 9, **dadurch gekennzeichnet, dass** aus den Brückensignalen nach Filterung und A/D-Wandlung Strom und Spannung gemäß folgender Vorschrift berechenbar sind:

$$(g_1 + g_2) \cdot I_P = F_1^{-1}(U_{B1}) + F_2^{-1}(U_{B2}) \qquad (3a)$$

$$(a_1 + a_2)\frac{U}{R} = F_1^{-1}(U_{B1}) - F_2^{-1}(U_{B2}) \qquad (3b)$$

$$\frac{(g_1 + g_2)}{(a_1 + a_2)} \approx 100...4000 \qquad (3c),$$

**11.** Vorrichtung nach Anspruch 10, **dadurch gekennzeichnet, dass** für die mittlere Leistung gilt:

$$\overline{P} = \frac{1}{T}\int_{t_0}^{t_0+T} P\,dt = \frac{1}{T}\int_{t_0}^{t_0+T} U \cdot I\,dt \qquad (4)$$

mit

$\overline{P}$: mittlere Leistung
P: Momentanleistung
T: Periodendauer
$t_0$: Startzeitpunkt

**Claims**

**1.** Apparatus for the DC-isolated measurement of the electrical power consumption of a two-terminal network from the detection of current and voltage in a circuit using XMR sensors which are connected to form Wheatstone bridges, wherein

- at least two Wheatstone bridges (10, 20) with the individual XMR sensors (11 to 14, 21 to 24) are arranged on a conductor loop (1) comprising a forward line and a return line (U-turn) in such a manner that, when a current flows through the conductor loop (1), gradient/difference fields ($H_{1v1}$, $H_{lv2}$) form in the region of the at least two Wheatstone bridges (10, 20) on account of the associated magnetic field, **characterized in that**
- at least two coil arrangements (15, 25) are arranged on the conductor loop in such a manner that, when the conductor loop (1) is energized, two different gradient/difference fields of the opposite direction are produced in the region of the two Wheatstone bridges (10, 20),
- and a series resistor (32) for energizing the at least two coil arrangements by means of the current flowing through it is provided for the purpose of measuring the voltage.

2. Apparatus according to Claim 1, **characterized in that** precisely two Wheatstone bridges (10, 20) are provided and are arranged above the conductor loop (1) in such a manner that they experience maximum detuning as a result of the respective gradient/difference field.

3. Apparatus according to Claim 2, **characterized in that** both Wheatstone bridges (10, 20) are situated in regions having a comparable magnetic field profile of the magnetic field caused by the primary current.

4. Apparatus according to one of the preceding claims, **characterized in that** the XMR sensors (11 to 14, 21 to 24) are AMR, GMR, TMR or OMR sensors, in particular GMR sensors.

5. Apparatus according to one of the preceding claims, **characterized in that** the series resistor provided for the purpose of measuring the voltage is a series resistor (32) of a few k$\Omega$.

6. Apparatus according to one of the preceding claims, **characterized in that** the at least two coil arrangements (15, 25) are in the form of flat coils.

7. Apparatus according to one of the preceding claims, **characterized in that** the series resistor (32) is arranged in operative connection to the two flat coils (15, 25).

8. Apparatus according to Claim 6, **characterized in that** the flat coils (15, 25) have a plurality of layers and, in the case of a small current ($I_V$), produce a gradient/difference field which substantially corresponds, in terms of magnitude, to the magnitude of the field of the primary current ($I_P$) during rated operation.

9. Apparatus according to Claim 8, **characterized in that** the following applies to the bridge voltages of the Wheatstone bridges (10, 20):

$$U_{B1} = F_1 \left( \varrho_1 \cdot I_p + a_1 \cdot \frac{U}{R} \right) \approx \overline{\varrho_1} \cdot I_p + \overline{a_1} \cdot \frac{U}{R} \tag{1}$$

$$U_{B2} = F_2 \left( \varrho_2 \cdot I_p - a_2 \cdot \frac{U}{R} \right) \approx \overline{\varrho_2} \cdot I_p - \overline{a_2} \cdot \frac{U}{R} \tag{2}$$

where the symbols have the following meaning:

$U_{B1}$: bridge voltage of the first bridge
$U_{B2}$: bridge voltage of the second bridge
R: series resistance
$I_p$: primary current
U: voltage
$F_{1,2}$: normalized transfer function of the bridge

$a_1$, $a_2$, $g_1$, $g_2$: scaling factors.

**10.** Apparatus according to Claim 9, **characterized in that** the current and voltage can be calculated from the bridge signals after filtering and A/D conversion according to the following rule:

$$(g_1 + g_2) \cdot I_{\wp} = F_1^{-1}(U_{B_1}) + F_2^{-1}(U_{B_2}) \tag{3a}$$

$$(a_1 + a_2)\frac{U}{R} = F_1^{-1}(U_{B1}) \quad F_2^{-1}(U_{B2}) \tag{3b}$$

$$\frac{(g_1 + g_2)}{(a_1 + a_2)} \approx 100 \ldots 4000 \tag{3c}.$$

**11.** Apparatus according to Claim 10, **characterized in that** the following applies to the average power:

$$\bar{P} = \frac{1}{T}\int_{t_0}^{t_0+T} P\,dt = \frac{1}{T}\int_{t_0}^{t_0+T} U \cdot I\,dt \tag{4}$$

where

$\bar{P}$: average power
P: instantaneous power
T: period duration
$t_0$: starting time.

**Revendications**

**1.** Dispositif de mesure galvanique séparée de l'absorption de puissance électrique d'un dipôle à partir de la détection du courant et de la tension dans un circuit électrique avec utilisation de capteurs XMR qui sont mis en circuit pour constituer des ponts de Wheatstone,

- au moins deux ponts de Wheatstone (10, 20) étant agencés de manière telle avec les capteurs XMR individuels (11 à 14, 21 à 24) sur une boucle conductrice (1) constituée d'une ligne aller et retour (U-Turn) que, lorsqu'un courant traverse la boucle conductrice (1), des champs de gradients / différentiels ($H_{Iv1}$, $H_{Iv2}$) se forment en raison du champ magnétique associé dans la zone des au moins deux ponts de Wheatstone (10, 20), **caractérisé en ce que**
- au moins deux agencements à bobine (15, 25) sont agencés de manière telle sur la boucle conductrice que, lorsque la boucle conductrice (1) est mise sous courant, deux champs de gradients / différentiels de sens opposés sont générés dans la zone des deux ponts de Wheatstone (10, 20), et
- une résistance additionnelle (32) servant à mettre sous courant les au moins deux agencements à bobine au moyen du courant qui la traverse étant présente pour la mesure de la tension.

**2.** Dispositif selon la revendication 1, **caractérisé en ce qu'**on a exactement deux ponts de Wheatstone (10, 20) qui sont agencés de manière telle au-dessus de la boucle conductrice (1) qu'ils sont désaccordés au maximum du fait du champ de gradients / différentiel respectif.

**3.** Dispositif selon la revendication 2, **caractérisé en ce que** les deux ponts de Wheatstone (10, 20) se trouvent dans des zones qui présentent un tracé comparable du champ magnétique créé par le courant primaire.

4. Dispositif selon l'une des revendications précédentes, **caractérisé en ce que** les capteurs XMR (11 à 14, 21 à 24) sont des capteurs AMR, GMR, TMR ou OMR, et plus particulièrement des capteurs GMR.

5. Dispositif selon l'une des revendications précédentes, **caractérisé en ce que** la résistance additionnelle présente pour la mesure de tension est une résistance additionnelle (32) de quelques kΩ.

6. Dispositif selon l'une des revendications précédentes, **caractérisé en ce que** les au moins deux agencements à bobine (15, 25) se présentent sous la forme de bobines plates.

7. Dispositif selon l'une des revendications précédentes, **caractérisé en ce que** la résistance additionnelle (32) se trouve en liaison active avec les deux bobines plates (15, 25).

8. Dispositif selon la revendication 6, **caractérisé en ce que** les bobines plates (15, 25) comportent plusieurs couches et génèrent, en présence d'un faible courant ($I_v$), un champ de gradients / différentiel qui, en valeur absolue et en fonctionnement nominal, correspond sensiblement à la valeur absolue du champ du courant primaire ($I_p$).

9. Dispositif selon la revendication 8, **caractérisé en ce qu'**on a, pour les tensions des ponts de Wheatstone (10, 20) :

$$U_{B1} = F_1\left(g_1 \cdot I_P + a_1 \cdot \frac{U}{R}\right) \approx \overline{g_1} \cdot I_P + \overline{a_1} \cdot \frac{U}{R} \qquad (1)$$

$$U_{B2} = F_2\left(g_2 \cdot I_P - a_2 \cdot \frac{U}{R}\right) \approx \overline{g_2} \cdot I_P - \overline{a_2} \cdot \frac{U}{R} \qquad (2)$$

où les symboles ont la signification suivante :

$U_{B1}$ : tension du premier pont,
$U_{B2}$ : tension du deuxième pont,
R : résistance additionnelle,
$I_P$ : courant primaire,
U : tension,
$F_{1,2}$ : fonction de transmission normalisée du pont, $a_1$, $a_2$, $g_1$, $g_2$ : facteurs d'échelle.

10. Dispositif selon la revendication 9, **caractérisé en ce que** le courant et la tension peuvent être calculés à partir des signaux de ponts après filtrage et conversion analogique-numérique selon la règle suivante :

$$(g_1 + g_2) \cdot I_P = F_1^{-1}(U_{B1}) + F_2^{-1}(U_{B2}) \qquad (3a)$$

$$(a_1 + a_2)\frac{U}{R} = F_1^{-1}(U_{B1}) - F_2^{-1}(U_{B2}) \qquad (3b)$$

$$\frac{(g_1 + g_2)}{(a_1 + a_2)} \approx 100...4000 \qquad (3c)$$

11. Dispositif selon la revendication 10, **caractérisé en ce qu'**on a, pour la puissance moyenne :

$$\overline{P} = \frac{1}{T} \int_{t_0}^{t_0+T} P \, dt = \frac{1}{T} \int_{t_0}^{t_0+T} U \cdot I \, dt \qquad\qquad (4)$$

où

$\overline{P}$ est la puissance moyenne,

P est la puissance instantanée, T est la durée de période et

$t_0$ est l'instant de départ.

FIG 1

$I_P$

15 13 14 $H_{I_P}$ 25 23 24 1

11 12 $H_{I_{v1}}$ $U/R = I$ 21 22 $H_{I_{v2}}$

$I_P$

FIG 2

$I_{V_1}$ 15 10 3 20 $I_{V_2}$ 25

2 1

$I_P$

FIG 3

$I_P$ 30

33 R 32

Leistungsdaten $I_V$

31 $I_V$ U

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3133908 A1
- EP 028679 A2
- US 4916455 A
- DE 4434417 A1